# EUROPÄISCHE PATENTSCHRIFT

(11) **EP 4 049 519 B1**
(45) Veröffentlichungstag und Bekanntmachung des Hinweises auf die Patenterteilung: **18.12.2024**
(21) Anmeldenummer: 20780156.4
(22) Anmeldetag: 23.09.2020
(51) Int. Cl.: H05K 7/20

(54) **VERFAHREN ZUM ERMITTELN EINES SOLL-VOLUMENSTROMS FÜR EIN KÜHLMITTEL**
METHOD FOR DETERMINING A TARGET VOLUMETRIC FLOW RATE FOR A COOLANT
PROCÉDÉ DE DÉTERMINATION D'UN DÉBIT VOLUMIQUE CIBLE D'UN FLUIDE DE REFROIDISSEMENT

(30) Priorität: 22.10.2019 DE 102019216218
(43) Veröffentlichungstag der Anmeldung: 31.08.2022
(73) Patentinhaber: Robert Bosch GmbH, 70442 Stuttgart (DE)
(72) Erfinder: MAUER, Jakob, 74343 Sachsenheim (DE)
(86) Internationale Anmeldenummer: PCT/EP2020/076534
(87) Internationale Veröffentlichungsnummer: WO 2021/078457

(56) Entgegenhaltungen:
- EP-A1- 2 907 688
- WO-A1-2020/156818
- DE-A1- 102016 212 192
- DE-T5- 112013 000 188

## Beschreibung

Die vorliegende Erfindung betrifft ein Verfahren zum Ermitteln eines Soll-Volumenstroms für ein Kühlmittel, das zur Kühlung eines Stromrichters durch einen Kühlmittelpfad geleitet wird, sowie eine Recheneinheit und ein Computerprogramm zu dessen Durchführung.

### Stand der Technik

Elektrische Maschinen können, insbesondere bei einem Einsatz in einem Fahrzeug, insbesondere einem Hybrid- oder Elektrofahrzeug, mittels eines Stromrichters betrieben werden. Insbesondere sind hierbei ein motorischer und ein generatorischer Betrieb möglich. Aufgrund der dabei entstehenden Wärme durch Verlustleistung im Stromrichter, dort insbesondere der Halbleiterschaltelemente bzw. Leistungshalbleiter, ist es zweckmäßig, solche Stromrichter mittels eines Kühlmittels, beispielsweise Wasser, zu kühlen. Aus den Druckschriften DE 10 2016 212192 A1, DE 11 2013 000188 T5 und EP 2 907 688 A1 sind Verfahren zum Ermitteln eines Soll-Volumenstroms für ein Kühlmittel bekannt.

### Offenbarung der Erfindung

Erfindungsgemäß werden ein Verfahren zum Ermitteln eines Soll-Volumenstroms sowie eine Recheneinheit und ein Computerprogramm zu dessen Durchführung mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung betrifft ein Verfahren zum Ermitteln eines Soll-Volumenstroms für ein Kühlmittel, das zur Kühlung eines Stromrichters durch einen Kühlmittelpfad geleitet wird. Bei einem solchen Stromrichter kann es sich insbesondere um einen Wechselrichter bzw. Inverter handeln. Wie schon erwähnt, weist ein solcher Stromrichter typischerweise Halbleiterschaltelemente, insbesondere Leistungshalbleiter wie MOSFETs oder IGBTs auf, um eine Spannung beispielsweise von einer Gleichspannung in eine Wechselspannung zu wandeln und umgekehrt. Je nach Art der mittels des Stromrichters anzusteuernden elektrischen Maschine und auch des Stromrichters selbst kann es insbesondere bei insgesamt hohen Leistungen, d.h. hohen Strömen, zu starker Erwärmung der Halbleiterschaltelemente und damit des Stromrichters aufgrund entsprechender Verlustleistung kommen.

Eine solche elektrische Maschine kann dabei insbesondere in einem Fahrzeug, insbesondere einem Hybrid- oder (reinen) Elektrofahrzeug, zum Einsatz kommen.

Typischerweise ist bei einem solchen Stromrichter bzw. allgemein bei Leistungselektronik daher eine Kühleinrichtung bzw. eine Möglichkeit zur Kühlung vorgesehen. Beispielsweise kann hierzu ein Kühlkörper verwendet werden, auf dem die Halbleiterschaltelemente und ggf. andere relevante Komponenten angeordnet sind, und an dem ein Kühlmittel in einem Kühlmittelpfad entlang geführt wird, um die entstehende Wärme abzuführen. Bei dem Kühlmittel kann es sich insbesondere um eine Flüssigkeit wie beispielsweise Wasser oder ein Wasser-Glykol-Gemisch handeln. Dabei kann der Kühlkörper Kühlrippen oder dergleichen aufweisen, die im Kühlmittelpfad liegen, um die entstehende Wärme möglichst effizient abführen zu können.

Für eine gezielte und möglichste effektive Ansteuerung einer entsprechenden Kühlmittelpumpe, mittels welcher das Kühlmittel entlang des Kühlmittelpfads gepumpt bzw. geleitet wird, ist eine Kenntnis über einen nötigen Volumenstrom des Kühlmittels, also einen Soll-Volumenstrom, gefordert. Einerseits soll nämlich der Stromrichter eine gewisse Temperatur nicht überschreiten, d.h. er soll vor Überhitzung geschützt werden, wofür ein hinreichend hoher Volumenstrom nötig ist, andererseits ist es aber auch unerwünscht, einen unnötig hohen Volumenstrom des Kühlmittels bereitzustellen, wozu unnötig Energie für den Betrieb der Kühlmittelpumpe nötig wäre.

Zur Ermittlung eines geeigneten Soll-Volumenstroms ist es möglich, eine Temperatur der Halbleiterschaltelemente bzw. der damit erzeugten und abzuführenden Wärme zu ermitteln. Hieraus kann dann ein geeigneter Soll-Volumenstrom ermittelt werden. Es hat sich nun aber gezeigt, dass auch durch die Berücksichtigung eines Zwischenkreiskondensators des Stromrichters und dessen Temperatur eine besonders genaue Ermittlung eines Soll-Volumenstroms für das Kühlmittel möglich ist.

Bei dem vorgeschlagenen Verfahren werden daher eine Temperatur des Zwischenkreiskondensators des Stromrichters und eine Temperatur des Kühlmittels ermittelt. Die Temperatur des Zwischenkreiskondensators kann beispielsweise mittels eines entsprechenden Temperatursensors direkt am Zwischenkreiskondensator gemessen werden (oder modelliert werden). Die Temperatur des Kühlmittels kann beispielsweise mittels eines Temperatursensors an einem Einlass des Kühlmittelpfads gemessen werden (oder modelliert werden). Denkbar ist aber auch eine Messung der Temperatur des Kühlmittels an einer anderen, geeigneten Stelle im Kühlmittelkreislauf, bevorzugt aber stromaufwärts und insbesondere in der Nähe des Kühlmittelpfads des Stromrichters.

Basierend auf einer Temperaturdifferenz der Temperatur des Zwischenkreiskondensators und der Temperatur des Kühlmittels wird dann ein Wert für den Soll-Volumenstrom ermittelt. Letzteres erfolgt bevorzugt dadurch, dass zunächst eine Temperaturdifferenz zwischen der Temperatur des Zwischenkreiskondensators und der Temperatur des Kühlmittels ermittelt wird und dann basierend auf der Temperaturdifferenz und der Temperatur des Kühlmittels der Wert für den Soll-Volumenstrom ermittelt wird. Zweckmäßigerweise wird dann eine Kühlmittelpumpe für das Kühlmittel basierend auf dem ermittelten Soll-Volumenstrom angesteuert bzw. geregelt. Der Soll-Volumenstrom für z.B. die Halbleiter kann eine eigene Funktion und somit unabhängig vom Kondensator sein. Nichtsdestotrotz ist der Soll-Volumenstrom für den Stromrichter bzw. Inverter eine max-Funktion aus Kondensator, Halbleiter und sonstigen Temperaturmodellen.

Anhand der Temperaturdifferenz zwischen den Temperaturen von Zwischenkreiskondensator - hierbei kann es sich insbesondere um einen Folienkondensator handeln - und Kühlmittel kann besonders einfach ermittelt werden, wie hoch ein Volumenstrom des Kühlmittels sein muss oder sein sollte, um eine abzuführenden Wärme auch abführen zu können. Die Temperaturdifferenz gibt dabei an, wieviel Wärme abzuführen ist, die Temperatur des Kühlmittels gibt an, wieviel Wärme das Kühlmittel noch aufnehmen kann. So kann ein bereits sehr warmes Kühlmittel in der Regel weniger Wärme (pro Volumen bzw. Masse) aufnehmen - und abführen - als ein kälteres Kühlmittel. Entsprechend sollte der Volumenstrom bei einem wärmeren Kühlmittel höher sein als bei einem kalten Kühlmittel.

Die Ermittlung des Soll-Volumenstroms kann dabei - ausgehend von der Temperaturdifferenz zwischen der Temperatur des Zwischenkreiskondensators und der Temperatur des Kühlmittels einerseits und der Temperatur des Kühlmittels anderseits - insbesondere anhand eines Kennfelds erfolgen. Dort können beispielsweise für verschiedene Werte der zwei genannten Größen jeweils geeignete Werte für den Soll-Volumenstrom hinterlegt sein. Diese können zuvor im Rahmen von Testmessungen und/oder Simulationen ermittelt worden sein.

Besonders bevorzugt ist es nun, wenn wenigstens ein Wert eines Stroms in dem Stromrichter ermittelt wird. Aus der Temperatur des Zwischenkreiskondensators und der Temperatur des Kühlmittels (bzw. der Temperaturdifferenz und der Temperatur des Kühlmittels) kann dann zunächst, insbesondere anhand des erwähnten Kennfelds, ein Zwischenwert für den Soll-Volumenstrom ermittelt bzw. bestimmt werden, der dann basierend auf dem wenigstens einen Wert des Stroms angepasst, insbesondere skaliert, wird und dann als der Wert für den Soll-Volumenstrom verwendet wird.

Als der wenigstens eine Wert des Stroms in dem Stromrichter kommt dabei insbesondere ein Wert eines Stroms in einem Zwischenkreis des Stromrichters und/oder ein Wert eines Phasenstroms in Betracht. Sowohl der Strom im Zwischenkreis als auch der Phasenstrom sind Größen, die einen aktuellen Betriebsstatus des Stromrichters charakterisieren, insbesondere hinsichtlich der aktuellen Verlustleistung und damit der entstehenden und abzuführenden Wärme. Dies gilt insbesondere aber auch für eine zukünftige Entwicklung der entstehenden und abzuführenden Wärme. Wenn nämlich die Ströme nur gering sind, kann davon ausgegangen werden, dass die entstehende und abzuführende Wärme abnehmen wird. Daher kann der Soll-Volumenstrom auch geringer gewählt werden. Entsprechend kann bei hohen Strömen der Soll-Volumenstrom höher bzw. weniger gering gewählt werden. Damit kann die Effizienz der Kühlung weiter gesteigert werden, bis hin zu dem Ziel, die Kühlmittelpumpe zumindest zeitweise, beispielsweise im Falle eines nicht aktiven Stromrichters, ganz abzustellen und somit Energie einzusparen und Emissionen zu senken.

Die Ermittlung des Soll-Volumenstroms bzw. eines aktuellen Werts hierfür erfolgt zweckmäßigerweise wiederholt, insbesondere regelmäßig, in bestimmten zeitlichen Abständen. Hierbei ist es dann bevorzugt, wenn ein zeitlicher Abstand zweier aufeinanderfolgender Ermittlungen des Wertes für den Soll-Volumenstrom in Abhängigkeit von einer Änderung eines Stroms in dem Stromrichter vorgegeben wird. Als der Strom in dem Stromrichter kann insbesondere einer der beiden vorstehend schon erwähnten Ströme, nämlich der Strom im Zwischenkreis oder der Phasenstrom, verwendet werden. Denkbar ist auch eine Verwendung beider Ströme, wobei dann beide betrachtet werden können und einer davon je nach Situation ausgewählt wird.

Zweckmäßig ist hierbei, wenn bei einem Anstieg des Stroms (also einem positiven Gradienten) in dem Stromrichter ein längerer zeitlicher Abstand vorgegeben wird als bei einem Absinken des Stroms (also einem negativen Gradienten) in dem Stromrichter. Auf diese Weise kann erreicht werden, dass etwaige nachteilige, thermische Effekte auftreten, beispielsweise kann ein Nachheizen vermieden werden. Das Aufheizen erfolgt in der Regel etwas schneller als das Abkühlen, weshalb hierzwischen unterschieden werden soll. Damit auch kein zu starker Nachheiz-Effekt entsteht, wird beim Abkühlen der Volumenstrom zweckmäßigerweise langsam geändert, während beim Aufheizen relativ zügig hoher Volumenstrom angefordert werden soll.

Eine erfindungsgemäße Recheneinheit, z.B. ein Steuergerät eines Kraftfahrzeugs oder einer Steuereinheit oder eine Leistungselektronik einer elektrischen Maschine, ist, insbesondere programmtechnisch, dazu eingerichtet, ein erfindungsgemäßes Verfahren durchzuführen.

Auch die Implementierung eines erfindungsgemäßen Verfahrens in Form eines Computerprogramms oder Computerprogrammprodukts mit Programmcode zur Durchführung aller Verfahrensschritte ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere magnetische, optische und elektrische Speicher, wie z.B. Festplatten, Flash-Speicher, EEPROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

Kurze Beschreibung der Zeichnungen
- Figur 1: zeigt schematisch einen Stromrichter, bei dem ein erfindungsgemäßes Verfahren durchführbar ist.
- Figur 2: zeigt den Stromrichter aus Figur 1 in einer anderen Darstellung.
- Figur 3: zeigt schematisch einen Ablauf eines erfindungsgemäßen Verfahrens in einer bevorzugten Ausführungsform.

### Ausführungsform(en) der Erfindung

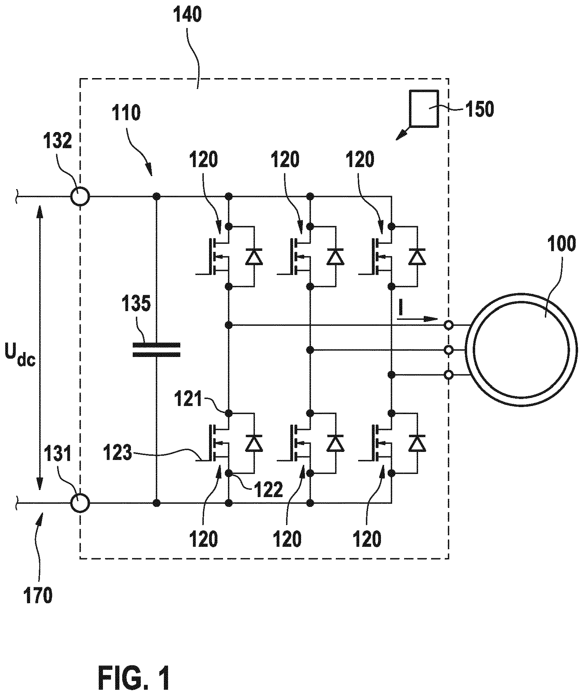

In Figur 1 ist schematisch ein beispielhaft als B6-Brücke ausgebildeter Stromrichter 110 dargestellt, bei dem ein erfindungsgemäßes Verfahren durchführbar ist und der zur Ansteuerung einer elektrischen Maschine 100 dient.

Der Stromrichter 110 weist zwei Gleichspannungsanschlüsse 131, 132 auf, die auf übliche Weise, neben einem beispielsweise als Folienkondensator ausgebildeten Zwischenkreiskondensator 135, mit beispielhaft sechs Halbleiterschaltelementen 120, beispielsweise MOSFETs oder IGBTs, verbunden sind. Zwischen jeweils zwei der Halbleiterschaltelemente 120 ist eine Phase (Ständerwicklung) der elektrischen Maschine 100 angeschlossen.

An dieser Stelle sei erwähnt, dass der Stromrichter nicht nur als Wechselrichter, sondern auch als Gleichrichter betrieben werden kann, sodass die elektrische Maschine insgesamt sowohl motorisch als auch generatorisch betreibbar ist.

Weiterhin ist der Stromrichter 110 mit seinen Gleichspannungsanschlüssen 131, 132 an ein Bordnetz 170, beispielsweise in einem Fahrzeug, angeschlossen. An das Bordnetz 170 wiederum sind typischerweise weitere Komponenten bzw. Verbraucher angebunden, die hier der Übersichtlichkeit halber jedoch nicht gezeigt sind.

Während eines Betriebs des Stromrichters 110 werden die einzelnen Halbleiterschaltelemente 120 nun mittels einer Ansteuerschaltung bzw. einer Ansteuereinheit 150 auf geeignete Weise zum Öffnen bzw. Schließen angesteuert. Dies erfolgt beispielsweise mit einer bestimmten Taktfrequenz. Bei einer üblichen Ansteuerung ist beispielsweise immer je Zweig ein Schalter geschlossen und der andere geöffnet. Dabei wird eine Gleichspannung U_{dc} in eine Wechselspannung gewandelt, sodass ein Phasenstrom I in den Phasen fließt.

Der Stromrichter 110 und optional die Ansteuereinheit 150 können dabei zusammen eine Leistungselektronik 140 für die elektrische Maschine 100 bilden oder Teil einer solchen Leistungselektronik sein. Insbesondere kann auch eine Messung eines Stroms bzw. Stromflusses sowie einer Spannung im Stromrichter erfolgen.

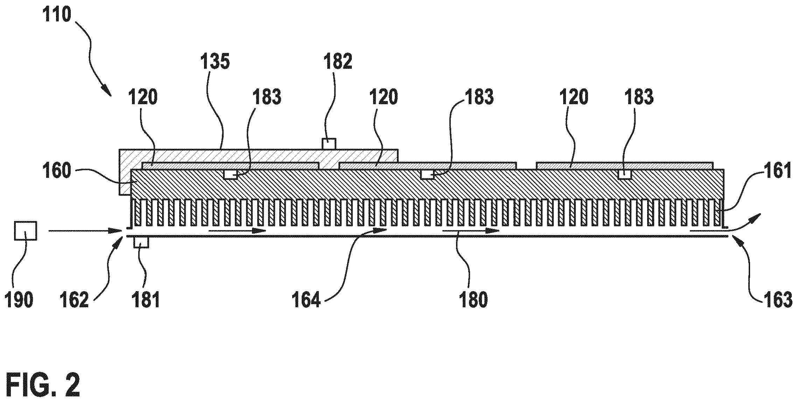

In Figur 2 ist der Stromrichter 110 aus Figur 1 in einer anderen Darstellung, in Schnittansicht, gezeigt. Insbesondere ist hier zusätzlich ein Kühlkörper 160 mit einer Vielzahl an Kühlrippen 161 gezeigt, an dessen Oberfläche die Halbleiterschaltelemente 120 angeordnet bzw. aufgebracht sind (in dieser Ansicht ist nur ein Halbleiterschaltelement pro Phase zu sehen). Durch eine geeignete Anbindung der Halbleiterschaltelemente 120 auf dem Kühlkörper 160 kann eine gute Wärmeübertragung von den Halbleiterschaltern 120 auf den Kühlkörper 160 erreicht werden. Zudem ist der Zwischenkreiskondensator 135 gezeigt, der ebenfalls am Kühlkörper 160 angeordnet sein kann, um eine effektive Kühlung zu ermöglichen.

Weiterhin ist ein Kühlmittelpfad 164 dargestellt, der beispielsweise durch ein geeignetes Gehäuse auf der den Halbleiterschaltelementen 120 gegenüberliegenden Seite des Kühlkörpers 160 begrenzt wird, sodass insbesondere auch die Kühlrippen 161 darin liegen. Der Kühlmittelpfad 164 weist einen Einlass 162 und einen Auslass 163 auf, sodass durch den Einlass 162 Kühlmittel, beispielsweise Wasser, das durch Pfeile 180 angedeutet ist, eintreten und durch den Auslass 163 wieder austreten kann. Auf diese Weise kann die Wärme vom Kühlkörper 160 an das Kühlmittel 180 abgegeben werden. Zum Pumpen des Kühlmittels 180 kann eine Kühlmittelpumpe verwendet werden, die beispielhaft mit dem Bezugszeichen 190 angedeutet ist.

Weiterhin sind sowohl am Einlass 162 des Kühlmittelpfads als auch am Zwischenkreiskondensator 135 jeweils ein Temperatursensor 181 bzw. 182 angebracht, womit eine Temperatur des Kühlmittels 180 am Einlass 162 des Kühlmittelpfads sowie eine Temperatur des Zwischenkreiskondensators 135 gemessen werden können. Weitere Temperatursensoren 183 können an den Halbleiterschaltelementen 120 vorgesehen sein.

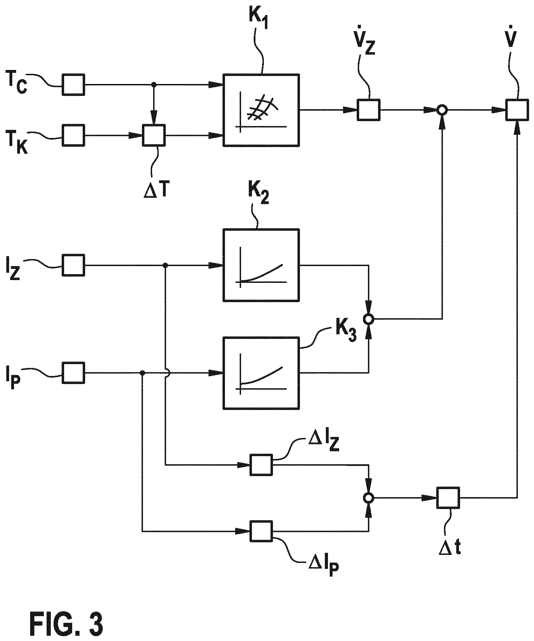

In Figur 3 ist schematisch ein Ablauf eines erfindungsgemäßen Verfahrens in einer bevorzugten Ausführungsform dargestellt. Zunächst werden die Temperatur T_{C} des Zwischenkreiskondensators sowie die Temperatur T_{K} des Kühlmittels ermittelt bzw. gemessen, beispielsweise mittels der in Bezug auf Figur 2 erwähnten Temperatursensoren.

Aus der Temperatur T_{C} und der Temperatur T_{K} kann dann eine Temperaturdifferenz ΔT gemäß der Formel ΔT=T_{C}-T_{K} gebildet werden. Basierend auf der Temperaturdifferenz ΔT und der Temperatur T_{K} des Kühlmittels kann dann anhand eines Kennfelds K₁ ein Zwischenwert V̇_{Z} des Soll-Volumenstroms für das Kühlmittel ermittelt bzw. bestimmt werden. Hierzu können die in dem Kennfeld K₁ hinterlegten Werte beispielsweise anhand von Testmessungen und/oder Simulationen ermittelt worden sein. Ebenso ist denkbar, dass die Temperaturdifferenz nicht explizit ermittelt bzw. berechnet wird, sondern die im Kennfeld hinterlegten Werte entsprechend direkt für die Temperaturen T_{C} und T_{K} gelten.

Weiterhin werden ein Strom I_{Z} im Zwischenkreis und/oder ein Phasenstrom I_{P} ermittelt bzw. mittels entsprechenden Sensoren oder Messeinrichtungen gemessen. Anhand einer jeweiligen Kennlinie K₁ bzw. K₂ kann dann jeweils ein Faktor ermittelt werden, mittels dessen der Zwischenwert V̇_{Z} angepasst, insbesondere herunterskaliert werden kann. Zweckmäßig ist dabei, nur einen der beiden Faktoren zu verwenden, nämlich insbesondere denjenigen, der zu einem höheren Soll-Volumenstrom führt, um etwaige Unsicherheiten abzufangen. Auf diese Weise wird dann der Soll-Volumenstrom V erhalten, anhand dessen die Kühlmittelpumpe angesteuert werden kann.

Wie schon erwähnt, kann dieser Soll-Volumenstrom regelmäßig ermittelt werden, um so immer den aktuell nötigen Wert für den Soll-Volumenstrom zu erhalten, um die Kühlmittelpumpe effizient zu betreiben, möglichst auch zeitweise abschalten zu können. In diesem Zusammenhang kann auch für den Strom I_{Z} im Zwischenkreis und/oder den Phasenstrom I_{P} jeweils eine Änderung bzw. ein Gradient ΔI_{Z} bzw. ΔI_{P} ermittelt werden. Wenn bei nur einem ermittelten Gradienten dieser positiv ist, d.h. der Strom ansteigt, kann ein zeitlicher Abstand Δt zwischen zwei aufeinanderfolgenden Ermittlungen des Wertes für den Soll-Volumenstrom V auf einen kleinen Wert gesetzt werden, andernfalls auf einen großen Wert.

Ein zeitlicher Abstand ist dabei zweckmäßigerweise über ein zeitliches Raster des verwendeten Modells vorgegeben, z.B. kann alle 100ms ein Aufruf der Funktion erfolgen. Werden zum Beispiel ein festes Drehmoment und eine feste Drehzahl gefahren, jedoch mit zwei unterschiedlichen Zwischenkreisspannungen, so ändert sich der Gradient des Zwischenkreisstromes, sodass entweder weniger oder mehr Wärme abgeführt werden muss. Bei unterschiedlichen Vorzeichen greift die max-Funktion, d.h. es wird der größere Wert verwendet.

## Patentansprüche

1. Verfahren zum Ermitteln eines Soll-Volumenstroms (V) für ein Kühlmittel (180), das zur Kühlung eines Stromrichters (110) durch einen Kühlmittelpfad (164) geleitet wird,
wobei eine Temperatur (T_{C}) eines Zwischenkreiskondensators (135) des Stromrichters (110) und eine Temperatur (T_{K}) des Kühlmittels ermittelt werden, und
wobei basierend auf einer Temperaturdifferenz (ΔT) der Temperatur (T_{C}) des Zwischenkreiskondensators und der Temperatur (T_{K}) des Kühlmittels ein Wert für den Soll-Volumenstrom (V) ermittelt wird,
**dadurch gekennzeichnet, dass** wenigstens ein Wert eines Stroms in dem Stromrichter ermittelt wird, und wobei basierend auf dem wenigstens einen Wert des Stroms ein, insbesondere anhand eines Kennfelds (K₁), aus der Temperatur (T_{C}) des Zwischenkreiskondensators und der Temperatur des Kühlmittels (T_{K}) ermittelter Zwischenwert (V̇_{Z}) für den Soll-Volumenstrom, angepasst, insbesondere skaliert, und als der Wert für den Soll-Volumenstrom (V̇) verwendet wird.

2. Verfahren nach Anspruch 1, wobei als der wenigstens eine Wert des Stroms in dem Stromrichter ein Wert eines Stroms (I_{Z}) in einem Zwischenkreis des Stromrichters und/oder ein Wert eines Phasenstroms (I_{P}) verwendet werden.

3. Verfahren nach einem der vorstehenden Ansprüche, wobei ein zeitlicher Abstand (Δt) zweier aufeinanderfolgender Ermittlungen des Wertes für den Soll-Volumenstrom (V) in Abhängigkeit von einer Änderung eines Stroms in dem Stromrichter vorgegeben wird.

4. Verfahren nach Anspruch 3, wobei bei einem Anstieg des Stroms in dem Stromrichter ein längerer zeitlicher Abstand vorgegeben wird als bei einem Absinken des Stroms in dem Stromrichter.

5. Verfahren nach einem der vorstehenden Ansprüche, wobei eine Kühlmittelpumpe (190) für das Kühlmittel (180) basierend auf dem ermittelten Soll-Volumenstrom (V) angesteuert wird.

6. Recheneinheit (140), die dazu eingerichtet ist, alle Verfahrensschritte eines Verfahrens nach einem der vorstehenden Ansprüche durchzuführen.

7. Computerprogramm, das eine Recheneinheit (140) dazu veranlasst, alle Verfahrensschritte eines Verfahrens nach einem der Ansprüche 1 bis 5 durchzuführen, wenn es auf der Recheneinheit (140) ausgeführt wird.

8. Maschinenlesbares Speichermedium mit einem darauf gespeicherten Computerprogramm nach Anspruch 7.

## Claims

1. Method for determining a target volumetric flow rate (V) for a coolant (180), which is conducted through a coolant path (164) to cool a power converter (110),
wherein a temperature (T_{C}) of a DC-link capacitor (135) of the power converter (110) and a temperature (T_{K}) of the coolant are determined, and
wherein a value for the target volumetric flow rate (V) is determined based on a temperature difference (ΔT) between the temperature (Tc) of the DC-link capacitor and the temperature (T_{K}) of the coolant,
**characterized in that** at least one value of a current in the power converter is determined, and wherein, based on the at least one value of the current, an intermediate value (*V̇*_{Z}) for the target volumetric flow rate determined from the temperature (T_{C}) of the DC-link capacitor and the temperature (T_{K}) of the coolant, in particular on the basis of a characteristic map (K₁), is adapted, in particular scaled, and used as the value for the target volumetric flow rate (V).

2. Method according to Claim 1, wherein a value of a current (I_{Z}) in a DC link of the power converter and/or a value of a phase current (I_{P}) is/are used as the at least one value of the current in the power converter.

3. Method according to any one of the preceding claims, wherein a time interval (Δt) between two successive determinations of the value for the target volumetric flow rate (V) is predefined as a function of a change of a current in the power converter.

4. Method according to Claim 3, wherein, upon an increase of the current in the power converter, a longer time interval is predefined than upon a decrease of the current in the power converter.

5. Method according to any one of the preceding claims, wherein a coolant pump (190) for the coolant (180) is activated based on the determined target volumetric flow rate (*V̇*).

6. Processing unit (140), which is configured to carry out all method steps of a method according to any one of the preceding claims.

7. Computer program, which causes a processing unit (140) to carry out all method steps of a method according to any one of Claims 1 to 5 when it is executed on the processing unit (140).

8. Machine-readable storage medium having a computer program according to Claim 7 stored thereon.

## Revendications

1. Procédé de détermination d'un débit volumique cible (V) d'un fluide de refroidissement (180) qui est guidé à travers un trajet de fluide de refroidissement (164) afin de refroidir un convertisseur de puissance (110),
une température (TC) d'un condensateur de circuit intermédiaire (135) du convertisseur de puissance (110) et une température (TK) du fluide de refroidissement étant déterminées, et
une valeur du débit volumique cible (V̇) étant déterminée sur la base d'une différence de température (DT) entre la température (TC) du condensateur de circuit intermédiaire et la température (TK) du fluide de refroidissement,
**caractérisé en ce qu'**au moins une valeur d'un courant dans le convertisseur de puissance est déterminée, et dans lequel une valeur intermédiaire (VZ) du débit volumique cible, déterminée sur la base de ladite au moins une valeur du courant, en particulier à l'aide d'un diagramme caractéristique (K1), à partir de la température (TC) du condensateur de circuit intermédiaire et de la température du fluide de refroidissement (TK), est ajustée, en particulier mise à l'échelle, et utilisée en tant que valeur du débit volumique cible (V).

2. Procédé selon la revendication 1, dans lequel une valeur d'un courant (IZ) dans un circuit intermédiaire du convertisseur et/ou une valeur d'un courant de phase (IP) sont utilisées en tant que ladite au moins une valeur du courant dans le convertisseur.

3. Procédé selon l'une quelconque des revendications précédentes, dans lequel un intervalle de temps (DT) entre deux déterminations successives de la valeur du débit volumique cible (V) est prédéfini en fonction d'une modification d'un courant dans le convertisseur.

4. Procédé selon la revendication 3, dans lequel, lors d'une augmentation du courant dans le convertisseur, un intervalle de temps plus long est prédéfini que lors d'une diminution du courant dans le convertisseur.

5. Procédé selon l'une quelconque des revendications précédentes, dans lequel une pompe à fluide de refroidissement (190) destinée au fluide de refroidissement (180) est commandée sur la base du débit volumique cible (V) déterminé.

6. Unité de calcul (140) conçue pour mettre en oeuvre toutes les étapes d'un procédé selon l'une quelconque des revendications précédentes.

7. Programme informatique qui amène une unité de calcul (140) à mettre en oeuvre toutes les étapes d'un procédé selon l'une quelconque des revendications 1 à 5 lorsqu'il est exécuté sur l'unité de calcul (140).

8. Support de stockage lisible par machine sur lequel est stocké un programme d'ordinateur selon la revendication 7.
